# EUROPEAN PATENT SPECIFICATION

(11) **EP 1 555 840 B1**
(45) Date of publication and mention of the grant of the patent: **20.06.2007**
(21) Application number: 04106324.9
(22) Date of filing: 06.12.2004
(51) Int. Cl.: H04Q 7/32, H03M 13/00

(54) **Converting binary data into SMS characters**
Umwandlung von binären Daten in SMS Zeichen
Conversion de données binaires en caractères SMS

(30) Priority: 12.12.2003 SE 0303337
(43) Date of publication of application: 20.07.2005
(73) Proprietor: Scania CV AB (publ), 151 87 Södertälje (SE)
(72) Inventor: Melander, Per, 756 43, Uppsala (SE)

(56) References cited:
- WO-A-01/41391
- WO-A-97/30556
- US-A- 5 353 328
- US-A1- 2003 045 311

## Description

### TECHNICAL FIELD

The invention relates generally to data transmission and more specifically to a method of processing data to be transferred via SMS and a method of processing data transferred via SMS.

### BACKGROUND OF THE INVENTION

Binary data cannot always be transferred directly in SMS (Short Message Service) messages in a GSM (Groupe Speciale Mobile) network from a computer in e.g. a vehicle to a central office without first being converted into SMS characters.

According to US 5,353,328, each byte of the binary data to be transferred is represented by two characters in hexadecimal code, i.e. a binary number needs two SMS characters. Thus, in an SMS message with a maximum of 160 characters, there is enough room for 80 bytes.

### SUMMARY OF THE INVENTION

The object of the invention is to increase the amount of data that can be transferred via an SMS message.

This is attained on the transmitting side by the method according to the invention of processing data to be transferred in an SMS message by converting each group of the data that comprises six bits or less into one of sixty-four SMS characters in accordance with a predetermined conversion table, dividing each group of the data that comprises more than six bits into separate 6-bit groups and converting each of the separate 6-bit group into an SMS character in accordance with the predetermined conversion table.

On the receiving side, this object is attained by the method according to the invention of processing data transferred as SMS characters by converting the SMS characters into 6-bit groups in accordance with the predetermined conversion table, and regrouping the bits of the 6-bit groups into groups corresponding to the original structure of the transferred data.

Hereby, in an SMS message with a maximum of 160 characters, in accordance with the invention, it will be possible to transfer 120 bytes.

### BRIEF DESCRIPTION OF THE DRAWING

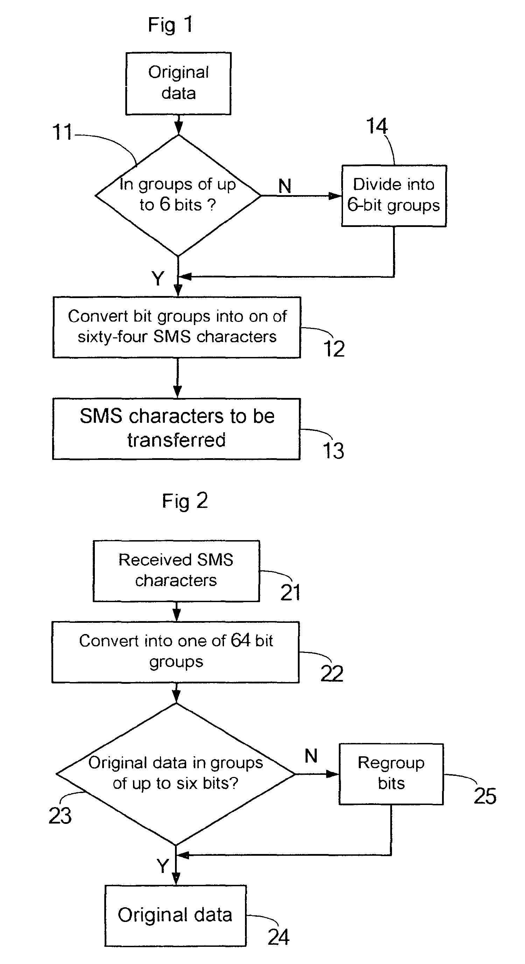

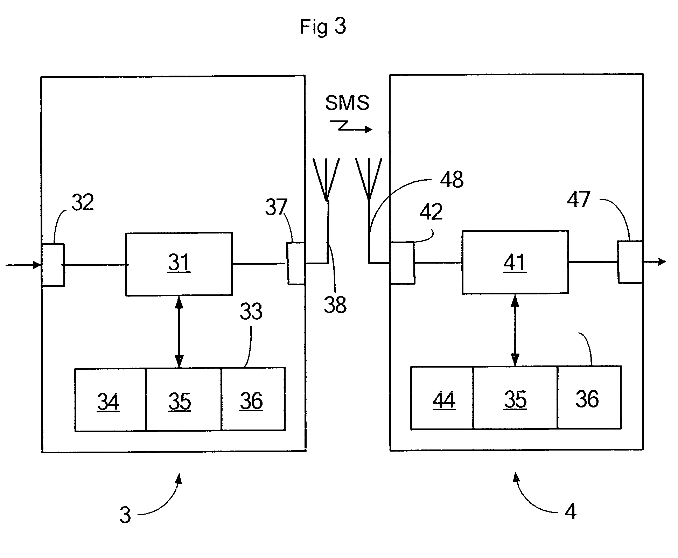

The invention will be described more in detail below with reference to the appended drawing on which Fig. 1 is a flow diagram illustrating the method according to the invention on the transmitting side, Fig. 2 is a flow diagram illustrating the method according to the invention on the receiving side, and Fig. 3 is a schematic illustration of an embodiment of a computer system for carrying out the methods illustrated in Fig. 1 and Fig. 2, respectively.

### DESCRIPTION OF THE INVENTION

Fig. 1 shows a flow diagram to illustrate steps of the method according to the invention of processing data to be transferred in an SMS message.

In Step 11, in accordance with the invention, it is queried whether the original data to be transferred is in bit groups of up to six bits or not from the beginning.

If the answer to the query in Step 11 is YES, in accordance with the invention, the bit groups that comprise six bits or less are each converted in Step 12 to one of sixty-four SMS characters in accordance with a conversion table of which Table 1 below is an example.

**Table 1**

| | | | | | | | | | | |
|---|---|---|---|---|---|---|---|---|---|---|
| | 0 | 1 | 2 | 3 | 4 | 5 | 6 | 7 | 8 | 9 |
| 0 | 0 | 1 | 2 | 3 | 4 | 5 | 6 | 7 | 8 | 9 |
| 10 | ! | ? | A | B | C | D | E | F | G | H |
| 20 | I | J | K | L | M | N | O | P | Q | R |
| 30 | S | T | U | V | W | X | Y | Z | a | b |
| 40 | c | d | e | f | g | h | i | j | k | l |
| 50 | m | n | o | p | q | r | s | t | u | v |
| 60 | w | x | y | z | | | | | | |

In Table 1, each decimal number between 0 and 63 and its corresponding binary number, i.e. 0 - 111111, corresponds to one of sixty-four predetermined SMS characters. The SMS characters of Table 1 are SMS characters that are the same with all GSM operators. It should be pointed out that Table 1 is merely an example and that the numbers in Table 1, of course, in another embodiment may correspond to any other of the sixty-four SMS characters.

After conversion of the groups of the data that comprises six bits or less in Step 12, the SMS characters are ready to be transferred in an SMS message in Step 13.

If the answer to the query in Step 11 is NO, i.e. the bit groups of the original data comprise more than six bits, e.g. eight, in Step 14 the data is first divided into separate 6-bit groups.

Then, in Step 12, each separate 6-bit group from Step 14 is converted into one of the sixty-four SMS characters in accordance with Table 1, whereupon the SMS characters so obtained are ready to be transferred in an SMS message in Step 13.

In accordance with the invention, it will be possible to transfer 120 bytes via an SMS message with a maximum of 160 characters.

Fig. 2 is a flow diagram to illustrate the steps of the method according to the invention of processing data transferred as SMS characters in an SMS message.

It is to be understood that the same Table 1, of course, has to be stored also on the receiving side.

In Step 21 in Fig. 2, SMS characters transferred from Step 13 in Fig. 1 are received.

In Step 22, according to the invention, each received SMS character is converted into one of sixty-four bit groups in accordance with Table 1 above.

In Step 23, it is queried whether the original data was in bit groups of up to six bits or not.

If the answer to the query in Step 23 is YES, i.e. the original data was in bit groups comprising six bits or less, the original data is obtained in Step 24.

If the answer to the query in Step 23 is NO, i.e. the original data was in bit groups comprising more than six bits, the bits of the bit groups obtained in Step 22 are regrouped in Step 25 to correspond to the original data.

The structure of the original data to be transferred can be either the same all the time, i.e. fixed, or different from time to time, i.e. vary.

In the first case, it has to be decided between the transmitting side and the receiving side that the data to be transferred always is of one and the same structure, e.g. that the original data always is in bytes, i.e. 8-bit groups.

In that case, the receiving side does not have to be further informed about the structure of the data that is transferred in the SMS message.

In the second case, the structure of the original data to be transferred differs from time to time.

In that case, the receiving side has to be informed in the SMS message about the actual structure of the transferred data, e.g. the distribution of 8-bit groups and groups of up to six bits in the original data.

The information of the structure of the transferred data is then inserted as e.g. a specific number in e.g. the header of the SMS message on the transmitting side and that number is interpreted on the receiving side to mean a specific structure.

### Example 1

Information is to be transferred from a computer in a vehicle, e.g. a truck, to a computer in a central office, that the actual speed of the vehicle is 85 km/h, that the maximum speed of the vehicle as set by the driver is 90 km/h, and that the engine speed is 1600 rpm.

To transfer that information via an SMS message would require eight SMS characters, namely 85901600.

The information in the computer in the vehicle is supposed to be represented in bytes, i.e. 8-bit groups.

In accordance with the invention, to be able to transfer the information via an SMS message, the information to be transferred is divided into separate 6-bit groups.
85 km/h is represented binary by 01010101.
90 km/h is represented binary by 01011010.
1600 rpm is represented binary by 0000011001000000.

Thus, the data to be transferred is: 01010101010110100000011001000000

By dividing that data into separate 6-bit groups, the following six 6-bit groups are obtained: 010101 010101 101000 000110 010000 00

After converting these 6-bit groups in accordance with Table 1, the following six SMS characters to be transferred via an SMS message are obtained: JJCGE0.

Thus, in accordance with the invention, instead of eight SMS characters, only six are needed to transfer the original data.

On the receiving side, these six SMS characters are converted into the above six bit groups by means of Table 1.

If the receiving side is aware of the fact that the transferred data originally was in bytes, the bits of the six bit groups are automatically regrouped to bytes to obtain the original data.

If not, information about the structure of the transferred data would have to be included in e.g. the header of the SMS message in order for the receiving side to be able to regroup the bits.

### Example 2

Information about the fact that the actual time is 11:30:45 is to be transferred from a computer in a vehicle, e.g. a truck, to a central office.

To transfer that information via an SMS message would require six SMS characters, namely 113045.

The time information is supposed to be represented binary by 6-bit groups from the beginning.

Thus,
11 is represented binary by 001011,
30 is represented binary by 011110, and
45 is represented binary by 101101,
i.e. the data to be transferred, i.e. 001011 011110 101101, is already present in 6-bit groups.

By means of Table 1, the following three SMS characters to be transferred to the central office are obtained: ?Sh.

Thus, instead of six SMS characters, only three have to be transferred according to the invention.

On the receiving side, these three SMS characters are converted into three bit groups by means of Table 1.

If the receiving side is aware of the fact that the transferred data originally was in 6-bit groups, the bits of the three bit groups automatically correspond to the original data.

If not, information about the structure of the transferred data would have had to be included in e.g. the header of the SMS message in order for the receiving side to be able to interpret the data.

If the above time information is not represented binary by 6-bit groups from the beginning but by actual binary numbers, i.e.
11 is represented binary by 1011,
30 is represented binary by 11110, and
45 is represented binary by 101101,
the data to be transferred is 1011 11110 101101.

Thus, the data to be transferred comprises one 4-bit group, one 5-bit group and one 6-bit group.

By means of Table 1, these bit groups are converted into the following three SMS characters to be transferred to the central office: ?Sh, i.e. the same as above.

Thus, as above, instead of six SMS characters, only three have to be transferred according to the invention.

On the receiving side, these three SMS characters are converted into three bit groups by means of Table 1.

In order for the receiving side to be able to properly interpret the data in this case, information about the structure of the transferred data, i.e. one 4-bit group, one 5-bit group and one 6-bit group, has to be included in e.g. the header of the SMS message.

Fig. 3 is a schematic illustration of an embodiment of a computer 3 for carrying out the steps in accordance with Fig. 1 on the transmitting side, and an embodiment of a computer 4 for carrying out the Steps in accordance with Fig. 2 on the receiving side.

The computer 3 on the transmitting side comprises a CPU 31 that is connected to an input port 32 for receiving input data to be processed in accordance with Fig. 1.

The CPU 31 is connected to a computer program product in the form of a storage unit 33 that stores a computer program 34, a conversion table 35, and data structure information 36.

The computer program 34 that can be present on a computer program product having a computer useable medium. The computer program 34 comprises code means that when executed causes the computer 3 to carry out the steps in accordance with Fig. 1 by means of the conversion table 35, e.g. Table 1, and the data structure information 36, i.e. information about whether the data structure is fixed or varies.

The resulting SMS characters are transferred to an output port 37 of the computer 3 and from there to e.g. a GSM telephone represented by an antenna 38 in Fig. 3.

The computer 4 on the receiving side comprises a CPU 41 that is connected to an input port 42 for receiving SMS characters to be processed in accordance with Fig. 2.

The input port 42 is in its turn connected to e.g. a GSM telephone represented by an antenna 48 in Fig. 3 for receiving the SMS characters that are transferred from the computer 3.

The CPU 41 is connected to a second storage unit 43 that stores a computer program 44, the same conversion table 35 and the same data structure information 36 as the storage unit 33 on the transmitting side.

The computer program 44 that here is present in the second storage unit 43 comprises code means that when executed, causes the computer 4 to carry out the steps in accordance with Fig. 2 by means of the conversion table 35, e.g. Table 1, and the data structure information 36, i.e. information about whether the data structure is fixed or varies.

The data resulting from the processing of the SMS characters is transferred to an output port 47 of the computer 4.

## Claims

1. A method of processing data to be transferred in an SMS message, **characterized by** the steps of
- converting each group of the data that comprises six bits or less into one of sixty-four SMS characters in accordance with a predetermined conversion table, and
- dividing each group of the data that comprises more than six bits into separate 6-bit groups and converting each of the separate 6-bit groups into an SMS character in accordance with the predetermined conversion table.

2. The method according to claim 1, **characterized by** predetermining the structure of the data to be transferred in the SMS message.

3. The method according to claim 2, **characterized by** inserting information about the structure of the data to be transferred in the header of the SMS message.

4. A computer (3) comprising means for carrying out all the steps of claim 1.

5. A computer program comprising code means that when executed on a computer (3), causes the computer (3) to carry out all the steps of claim 1.

6. A method of processing data transferred as SMS characters in accordance with claim 1, **characterized by** the steps of
- converting the SMS characters into 6-bit groups in accordance with the predetermined conversion table,
- regrouping the bits of the 6-bit groups into groups corresponding to the original structure of the transferred data.

7. The method according to claim 6, **characterized by** regrouping the bits of the 6-bit groups in a predetermined manner.

8. The method according to claim 6, **characterized by** regrouping the bits of the 6-bit groups in response to information about the structure of the received data inserted into the header of the received SMS message.

9. A computer (4) comprising means for carrying out all the steps of claim 6.

10. A computer program comprising code means that when executed on a computer (4) causes the computer to carry out all the steps of claim 6.

11. A computer program product comprising a computer usable medium and a computer program according to claim 5 or 10, wherein the computer program is comprised in the computer usable medium.

## Patentansprüche

1. Verfahren zum Verarbeiten von Daten, die in einer SMS-Nachricht zu übertragen sind, **gekennzeichnet durch** die Schritte:
- Umwandeln jeder Gruppe der Daten, die 6 Bits oder weniger umfasst, in eines von 64 SMS-Zeichen nach Maßgabe einer vorbestimmten Konversionstabelle, und
- Teilen jeder Gruppe der Daten, die mehr als 6 Bits umfasst, in einzelne 6-Bit-Gruppen und Umwandeln jeder separaten 6-Bit-Gruppe in ein SMS-Zeichen nach Maßgabe der vorbestimmten Konversionstabelle.

2. Verfahren nach Anspruch 1, **gekennzeichnet durch** das Bestimmen der Struktur der in der SMS-Nachricht zu übertragenden Daten.

3. Verfahren nach Anspruch 2, **gekennzeichnet durch** das Einsetzen von Information über Struktur der zu übertragenden Daten in dem Anfangsblock der SMS-Nachricht.

4. Computer (3), umfassend Mittel zum Ausführen der Schritte nach Anspruch 1.

5. Computerprogramm, umfassend Codemittel, die dann, wenn sie auf einem Computer (3) ausgeführt werden, bewirken, dass der Computer (3) alle Schritte des Anspruchs 1 ausführt.

6. Verfahren zum Verarbeiten von als SMS-Zeichen zu übertragende Daten gemäß Anspruch 1, **gekennzeichnet durch** die Schritte:
- Umwandeln der SMS-Zeichen in 6-Bit-Gruppen nach Maßgabe der vorbestimmten Konversionstabelle,
- erneutes Gruppieren der Bits der 6-Bit-Gruppen in Gruppen entsprechend der ursprünglichen Struktur der übertragenen Daten.

7. Verfahren nach Anspruch 6, **gekennzeichnet durch** ein erneutes Gruppieren der Bits der 6-Bit-Gruppen in einer vorbestimmten Weise.

8. Verfahren nach Anspruch 6, **gekennzeichnet durch** erneutes Gruppieren der Bits der 6-Bit-Gruppen in Antwort auf eine Information über die Struktur der empfangenen Daten, die in den Anfangsblock der empfangenen SMS-Nachricht eingesetzt sind.

9. Computer (4), umfassend Mittel zum Ausführen der Schritte nach Anspruch 6.

10. Computerprogramm, umfassend Codemittel, die dann, wenn sie auf einem Computer (4) ausgeführt werden, bewirken, dass der Computer die Schritte nach Anspruch 6 ausführt.

11. Computerprogrammprodukt, umfassend ein von einem Computer nutzbares Medium und ein Computerprogramm nach Anspruch 5 oder 10, wobei das Computerprogramm auf dem vom Computer nutzbaren Medium enthalten ist.

## Revendications

1. Procédé de traitement de données devant être transférées dans un message SMS, **caractérisé par** les étapes de :
- conversion de chaque groupe des données qui comporte six bits ou moins dans un de soixante-quatre caractères SMS conformément à une table de conversion prédéterminée et
- division de chaque groupe des données qui comporte plus de six bits dans des groupes séparés à 6 bits et conversion de chacun des groupes séparés à 6 bits en un caractère SMS conformément à la table de conversion prédéterminée.

2. Procédé selon la revendication 1, **caractérisé par** la prédétermination de la structure des données devant être transférées dans le message SMS.

3. Procédé selon la revendication 2, **caractérisé par** l'insertion d'informations autour de la structure des données devant être transférées dans l'en-tête du message SMS.

4. Ordinateur (3) comprenant des moyens pour la mise en oeuvre de toutes les étapes de la revendication 1.

5. Programme d'ordinateur comprenant des moyens de code qui, lorsqu'ils sont exécutés sur un ordinateur (3) provoquent que l'ordinateur (3) mette en oeuvre toutes les étapes de la revendication 1.

6. Procédé de traitement de données transférées comme des caractères SMS selon la revendication 1, **caractérisé par** les étapes de :
- transformation des caractères SMS en groupes à 6 bits conformément à la table de conversion prédéterminée,
- regroupement des bits des groupes à 6 bits en groupes correspondant à la structure d'origine des données transférées.

7. Procédé selon la revendication 6, **caractérisé par** le regroupement des bits des groupes à 6 bits d'une façon prédéterminée.

8. Procédé selon la revendication 6, **caractérisé par** le regroupement des bits des groupes à 6 bits en réponse à l'information sur la structure des données reçues insérées dans l'en-tête du message SMS reçu.

9. Ordinateur (4) comprenant des moyens pour la mise en oeuvre de toutes les étapes de la revendication 6.

10. Programme d'ordinateur comprenant des moyens de code qui, lorsqu'ils sont exécutés sur un ordinateur (4) provoquent que l'ordinateur mette en oeuvre toutes les étapes de la revendication 6.

11. Programme d'ordinateur comprenant un milieu utilisable d'ordinateur et un programme d'ordinateur selon la revendication 5 ou 10, dans lequel le programme d'ordinateur est compris dans le milieu utilisable d'ordinateur.
